(19) Europäisches Patentamt

European Patent Office

Office européen des brevets

(11) **EP 0 663 723 B1**

(12) **EUROPEAN PATENT SPECIFICATION**

(45) Date of publication and mention
of the grant of the patent:
**04.10.2000 Bulletin 2000/40**

(51) Int Cl.[7]: **H03H 11/04**

(86) International application number:
**PCT/JP94/01234**

(21) Application number: **94921821.8**

(22) Date of filing: **26.07.1994**

(87) International publication number:
**WO 95/04401 (09.02.1995 Gazette 1995/07)**

(54) **FILTER CIRCUIT**

**FILTERSCHALTUNG**

**CIRCUIT FILTRANT**

(84) Designated Contracting States:
**DE FR GB**

(30) Priority: **27.07.1993 JP 18425693**
**09.02.1994 JP 1473394**

(43) Date of publication of application:
**19.07.1995 Bulletin 1995/29**

(60) Divisional application: **98120133.8 / 0 915 565**
**99114140.9 / 0 951 144**

(73) Proprietor: **FUJITSU LIMITED**
**Kawasaki-shi, Kanagawa 211 (JP)**

(72) Inventors:
• **YAMAMOTO, Takuji**
**Nakahara-ku Kawasaki-shi Kanagawa 211 (JP)**

• **KUWATA, Naoki**
**Nakahara-ku Kawasaki-shi Kanagawa 211 (JP)**

(74) Representative: **Lehn, Werner, Dipl.-Ing. et al**
**Hoffmann Eitle,**
**Patent- und Rechtsanwälte,**
**Arabellastrasse 4**
**81925 München (DE)**

(56) References cited:
| | |
|---|---|
| EP-A- 0 125 426 | GB-A- 2 077 559 |
| JP-A- 2 202 212 | JP-A- 4 023 607 |
| JP-A- 4 150 513 | JP-A- 51 040 737 |
| JP-A- 56 166 616 | JP-A- 62 160 809 |
| JP-U- 2 044 425 | JP-U- 4 057 979 |
| JP-U- 49 036 839 | JP-U- 49 148 838 |
| JP-U- 54 135 137 | |

**Description**

TECHNICAL FIELD

The present invention relates to a filter circuit which is suitable for conversion to an integrated circuit formed of transistors or field-effect transistors and controls the frequency band of the amplifying circuit used for the signal receiver, for example, within an optical communications system.

BACKGROUND ART

In the receiving unit arranged in an optical communications system, plural filter circuits are used in accordance with purposes. That is, the equalizing and amplifying circuit needs a low-pass filter circuit to have the optimum frequency band and optimum cut-off characteristic determined in the waveform interference/noise band tradeoffs. The timing-clock amplifying circuit needs a low-pass filter, a high-pass filter, or a band-pass filter each of which suppresses the jitter due to circuit noises and prevents erroneous operation due to harmonic components.

Recently, the optical communications systems which operate at a high transmission speed of 2.4 Gb/s are already in an actual use. The development of the system operating as speed as 5Gb/s to 10Gb/s is being spurred. With this system development, the filter circuit must operate at operable frequencies of several GHz to 10 GHz to be used for the amplifying circuit.

Moreover, the filter circuit which can vary its cut-off frequency and center frequency is needed in order to share a filter circuit used in a system which operates at a different transmission speed and to suppress the characteristic deviation due to variations between the circuit forming components and characteristic variation due to characteristic drifts in circuit elements.

In the optical communications systems, the system forming circuits have evolved from discrete-parts assembled circuits into integrated circuits. Moreover, the integrating technology with which analog circuits and digital circuits are formed on a semiconductor chip has been in practical use. Hence it is desirable to match the filter circuit to the above-mentioned technology. The active filter circuit can respond to such a demand.

An active filter circuit formed of an operational amplifier and a CR circuit has been first developed. The reason is that utilizing the high gain, very high input impedance, and low output impedance of the operational amplifier allows the simple circuit design.

However, the operational amplifier cannot be used for the above-mentioned high-speed system because its effective frequency range is narrow. Hence, the art which can construct an active filter circuit formed of wide-range operable active elements has been more concerned importantly.

In order to deal with plural transmission speeds with the same integrated circuit and to provide general versatility, a filter circuit that can vary its frequency over a wide range is required.

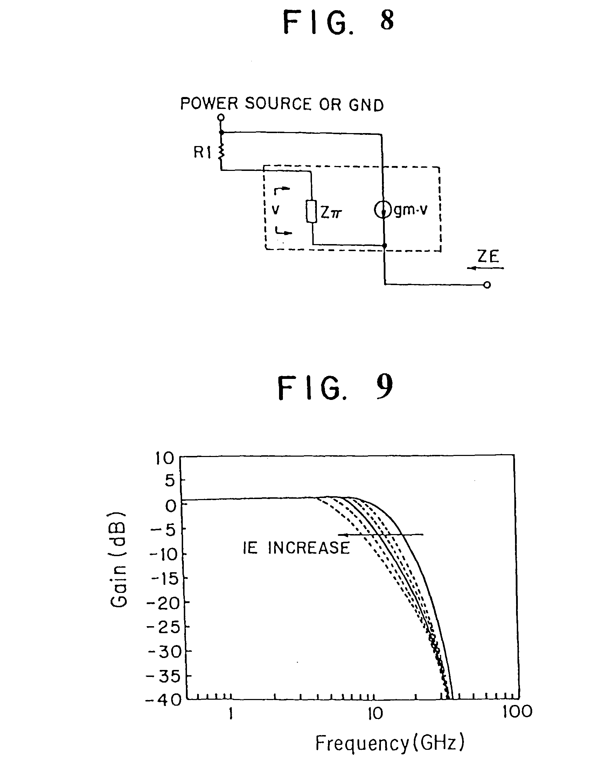

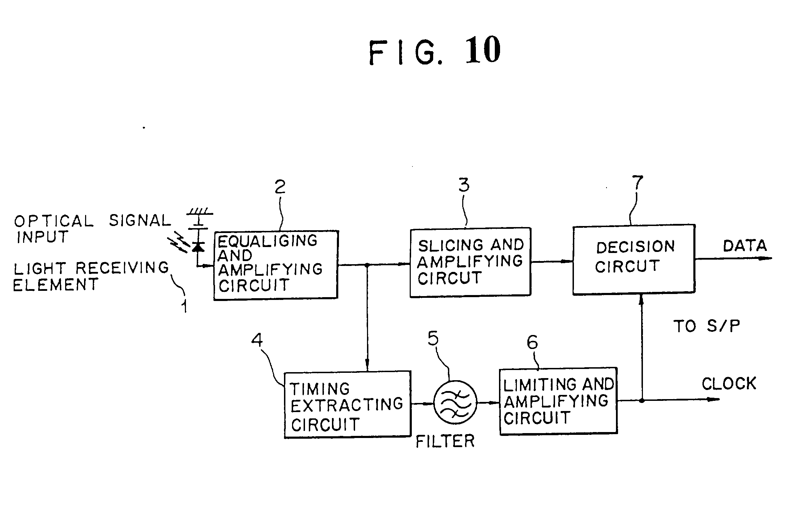

Fig. 10 is a diagram showing the constructional example of the optical signal receiving unit arranged in an optical communications system. Referring to Fig. 10, numeral 1 represents a light receiving element, 2 represents an equalizing and amplifying circuit, 3 represents a slicing and amplifying circuit, 4 represents a timing extracting circuit, 5 represents a filter, 6 represents a limiting and amplifying circuit, and 7 represents a decision circuit.

The light receiving element 1 converts an optical signal into an electrical signal. The equalizing and amplifying circuit 2 amplifies linearly an electrical signal converted by the light receiving element 1 to a predetermined amplitude. The slicing and amplifying circuit 3 slices the signal amplified by the equalizing and amplifying circuit 2.

The timing extracting circuit 4 extracts a frequency timing of the signal amplified by the equalizing and amplifying circuit 2 to output clocks pulses. The filter 5 reduces noises included in the clock. The limiting and amplifying circuit 6 limit-amplifies the clock passed through the filter 5 to a predetermined amplitude.

The decision circuit 7 discriminates the data signal amplified by the slicing and amplifying circuit 3 in response to the clock signal amplified by the limiting and amplifying circuit 6 to output data.

The optical signal receiving unit with the above-mentioned structure can amplify the signal weakened due to the long distance transmission in an optical communications system.

In the equalizing and amplifying circuit 2, the S/N ratio is degraded because of the widened noise range in an excessively widened frequency range. On the contrary, the receiving sensitivity is degraded because of an increased waveform interference when the frequency range is excessively narrowed.

Since the equalizing and amplifying circuit 2 has the optimum frequency range according to the applicable transmission speed in the equilibrium of noise range and waveform interference, it is necessary to build an active low-pass filter circuit with good performance in the equalizing and amplifying circuit 2 in an integrated circuit form.

In order to suppress jitter due to internal noises therein and to prevent an erroneous circuit operation due to harmonic components produced in its limiting and amplification, the limiting and amplifying circuit 6 needs its tuning characteristic. In order to realize the tuning characteristic in the integrated circuit, the active filter circuit such as a low-pass filter circuit, a high-pass filter circuit, or a band-pass filter is needed.

In any cases, it is needed that the frequency-band variable filter circuit can vary its characteristic to deal with range variations or unintentional peaking due to manufactual variations of an integrated circuit including the above-mentioned amplifying circuit.

A prior-art active filter circuit and frequency-range variable filter circuit will be described below.

First, a prior-art active filter circuit will be described below.

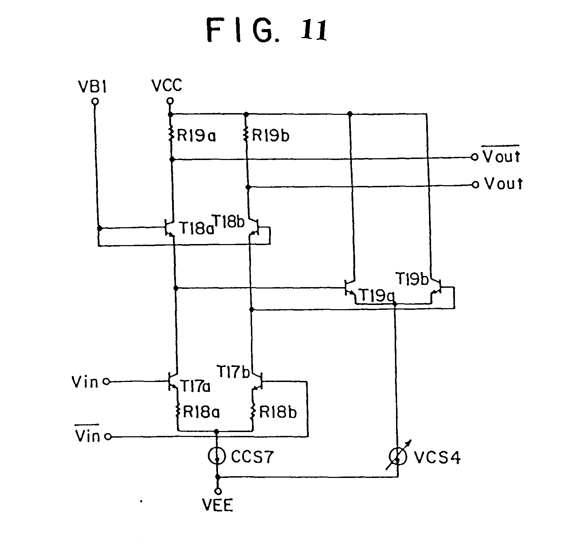

Fig. 11 is a diagram showing a prior art active low-pass filter circuit. Referring to Fig. 11, symbols T17a and T17b represent input transistors; T18a and T18b represents resistors, or output transistors, each of which decides the cut-off frequency; T19a and T19b represent capacitors each of which decides the cut-off frequency; R18a and R18b represent resistors each of which converts an input voltage into a current; R19a and R19b represents resistors each of which converts a current into a voltage or output voltage.

The circuit, shown in Fig. 11, is a RC filter circuit with a first-order cut-off characteristic which is formed of a resistor counting each of the transistors T18a and T18b and a capacitance counting each of the transistors T19a and T19b.

If the current amplification constant $\beta o$ of each of the transistors T18a and T18b is sufficiently large, the resistors counting the transistors T18a and T18b correspond to the emitter resistor $r_e$, respectively. Because the juncture between the emitters of the transistors T19a and T19b is regarded as an imaginary ground, the capacitance counting the transistors T19a and T19b is the sum of the collector junction capacitance $C_{JC}$, the emitter junction capacitance $C_{JE}$, and the emitter diffusion capacitor Cd. Hence the cut-off frequency fc is expressed by the following formula:

$$fc = 1/ [2\pi r_e (Cd + C_{JE} + C_{JC})]$$

The filter circuit, shown in Fig. 11, can adjust its cut-off frequency by controlling the bias current of each of the transistors T19a and T19b because the emitter diffusion capacitance Cd is proportional to the emitter current (in a normal bias condition of $Cd \gg C_{JE}$, $C_{JC}$ is established).

This circuit can be used as a balanced circuit in which an input voltage is applied between the base of the transistor T17a and the base of the transistor T17b to produce the output between the collector of the transistor T18a and the collector of the transistor T18b, a unbalanced circuit in which an input voltage is input between the base of the transistor T17a or T17b and the ground to produce an output between the collector of the transistor T18a or T18b and the ground, or a circuit which has a balanced input and a unbalanced output, and vice versa.

However, since the circuit, shown in Fig. 11, is a primary filter circuit (with a first-order cut-off characteristic), the secondary filter circuit (with a second-order cut-off characteristic) may be realized by cascading the same circuits (shown in Fig. 11) or by using a LCR filter circuit with secondary characteristic) including a coil (L) and a capacitor (C).

In the former case, there is a disadvantage in that cascading the primary active filter circuits decreases the cut-off frequency. The practical active filter circuit needs the voltage shift circuit added therein, shown in Fig. 11, thus causing the large circuit scale.

Turning to the latter case, in order to realize the LCR filter circuit with a secondary characteristic formed of coils and capacitors, there is a disadvantage in that a coil cannot be suited to the integrated circuit and the complicated coil equivalent circuit makes it difficult to control the characteristic.

From JP-A-51 40737 a filter circuit is known wherein the emitter of a transistor is connected to ground via a parallel RC arrangement.

The present invention is made to overcome the above mentioned problems. An object of the present invention is to provide a filter circuit suitable for integrated circuits which has a secondary cut-off characteristic showing a wide, stable, variable frequency range without deteriorating the maximum frequency range of the entire circuit.

## DISCLOSURE OF INVENTION

According to the present invention, the filter circuit comprises a first transistor having a base or gate connected to ground or power source via a first resistor; a second resistor and a capacitor each having one end connected to an emitter or source of the first transistor and the other terminal connected to said ground or said power source; a current input at a juncture at which said second resistor, said capacitor, and said first transistor are connected together; and a collector or drain of said first transistor connected to constitute a current output.

According to the present invention, the filter circuit can constitute an active secondary low-pass filter circuit thus varying broadly its cut-off frequency.

**BRIEF DESCRIPTION OF DRAWINGS**

Figs. 1(a) and 1(b) are diagrams each explaining the first aspect of the active filter according to the present invention;

Fig. 2 is a diagram explaining the active filter circuit according to the first embodiment of the present invention;

Fig. 3 is a diagram explaining the active filter circuit according to the second embodiment of the present invention;

Fig. 4 is a diagram explaining the active filter circuit according to the third embodiment of the present invention;

Fig. 5 is a diagram explaining the active filter circuit according to the fourth embodiment of the present invention;

Fig. 6 is a diagram explaining the active filter circuit according to the fifth embodiment of the present invention;

Fig. 7 is a diagram explaining the active filter circuit according to the sixth embodiment of the present invention;

Fig. 8 is a diagram showing an equivalent circuit to calculate the impedance in expectation of the emitter;

Fig. 9 is a graph showing the resultant simulation;

Fig. 10 is a diagram showing the configuration of the optical signal receiving unit in an optical communications system; and

Fig. 11 is a diagram showing an example of a conventional active filter circuit.

BEST MODE FOR CARRYING OUT THE INVENTION

The embodiments according to the present invention will be described below with reference to the attached drawings. (a) The fundamental explanation of the portion related to the active filter circuit according to the present invention:

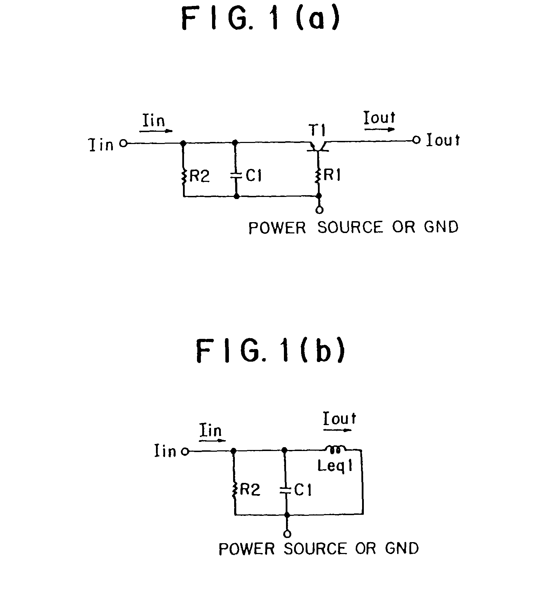

Fig. 1 is a diagram showing a first aspect of the present invention. Fig. 1(a) is a structural diagram showing the secondary low-pass filter circuit. Fig. 1(b) is a diagram showing the equivalent circuit of the secondary low-pass filter circuit.

Referring to Fig. 1(a), symbol T1 represents a transistor forming a coil, R1 and R2 represent resistors, and C1 represents a capacitor. Now when it is assumed that an input current is the current flowing into the emitter of the transistor T1, the resistor R2, and the capacitor C1 and an output current is the current derived from the collector of the transistor T1, the current transfer function of the circuit shown in Fig. 1(a) is calculated with reference to Fig. 8.

That is, Fig. 8 is a diagram showing an equivalent circuit used for calculating the impedance counting the emitter of the transistor T1 shown in Fig. 1(a). Referring to Fig. 8, R1 corresponds to the resistor R1 shown in Fig. 1(a) and $Z\pi$ is the base to emitter impedance of the $\pi$-type equivalent circuit of a transistor. gm is a transconductance of the transistor, v is the terminal voltage of the impedance $Z\pi$, and gm•V is a collector current source of the transistor.

Referring to the equivalent circuit shown in Fig. 8, the impedance counting the emitter of the transistor is expressed as follows:

$$Z_E = 1/gm + R_1 \, (1/\beta o + \Omega^2) \, / \, (1 + \Omega^2)$$

$$+ \, j \, \Omega \, (R_1 - 1/gm)/(1 + \Omega^2) \qquad (1)$$

where $\Omega = \omega / \omega_T$, $\omega = 2\pi f$ (f is a frequency), $\omega_T = 2\pi f_T$ ($f_T$ is the transition frequency of a transistor), $\beta o$ is a common-emitter current gain, and R1 is the resistance value of the resistor R1. Hereinafter, the resistance of the resistor RN is denoted as Rn and the capacitance of the capacitor CN is denoted as Cn.

Now, by setting R1 $>> g_m$ 1/gm and applying 1 $>>$ 1/$\beta o$, usually applicable, to the formula (1), the following approximate formula holds within the frequency range of 1 $>> (\omega / \omega_T)^2$:

$$Z_E \fallingdotseq j\omega R1 \, / \, \omega_T \qquad (2)$$

Hence, the equivalent element forming $Z_E$ shown in Fig. 8 is an equivalent inductance expressed by the following formula:

$$Leq \fallingdotseq R1 \, / \, \omega_T \qquad (3)$$

The equivalent circuit shown in Fig. 1(b) is obtained by substituting the equivalent inductance expressed by the formula (3) for the transistor T1 shown in Fig. 1(a).

The current transfer function (Iout/Iin) of the equivalent circuit shown in Fig. 1(b) is expressed as follows:

$$Iout/Iin = (1/C_1 Leq_1) / [s^2 + (1/C_1 R_2) s + 1/C_1 Leq_1] \tag{4}$$

where $Leq1 = R1 / \omega_T$.

The cut-off frequency $\omega o$ and Q of the low-pass filter circuit are expressed by the following formulas:

$$\omega o = 1 / C_1^{1/2} Leq_1^{1/2} \tag{5}$$

$$Q = \omega o\ R_2\ C_1 \tag{6}$$

In other words, the circuit shown in Fig. 1(a) is a low-pass filter circuit having a secondary cut-off characteristic in which current is input and output.

As described above, in the filter circuit according to the first aspect of the present invention, the characteristic of a coil is realized by a transistor. Hence a current input/output type LCR low-pass filter circuit with a secondary cut-off characteristic can be constructed without using a discrete coil (L) component. There is an advantage in that this feature allows the current input/output type low-pass filter circuit to be integrated very easily.

Explanation of the Embodiment of the Active Filter Circuit:

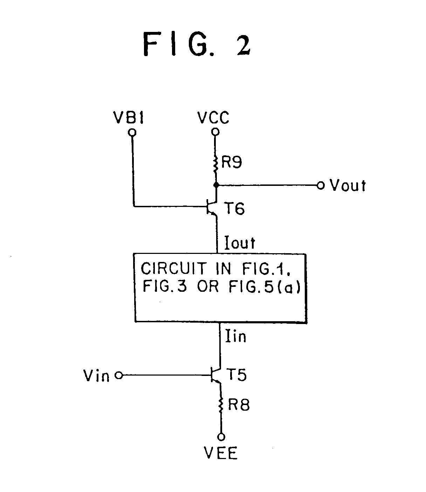

Fig 2 is a diagram showing the active filter circuit according to the first embodiment of the present invention. Referring to Fig. 2, symbol T5 represents an input transistor, T6 represents an output transistor, and R8 and R9 represent resistors. The input terminal of the circuit shown in Fig. 1(a) is connected to the collector of the transistor T5. The output terminal of the circuit shown in Fig. 1(a) is connected to the emitter of the transistor T6.

If current Iin and Iout are ignored, Vin = Iin R8 and Vout = Iout R9.

$$\text{Hence, } Vout/Vin = (R_9/R_8)\ (Iout/Iin) \tag{26}$$

The first aspect of the active filter circuit according to the present invention corresponds to the secondary low-pass filter circuit which is expressed as the current transfer function of the formula (4). However, actual filter circuits can be easily realized by converting the transfer function into a voltage transfer function. This feature enables the down-sized system, in addition to an largely improved performance of the system such as an optical communications system.

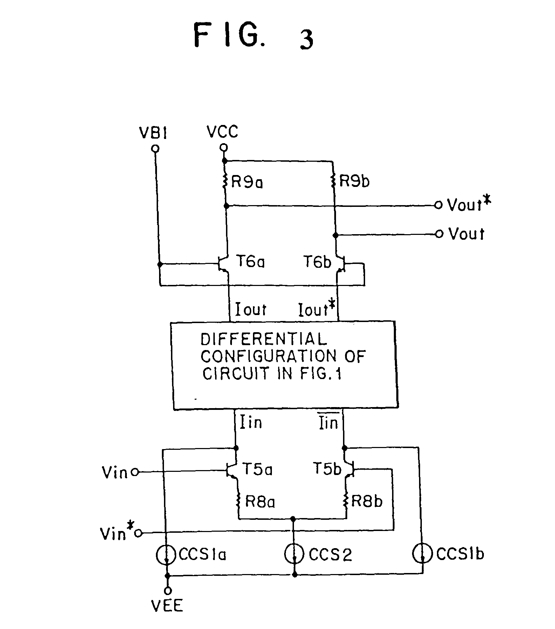

Fig. 3 is a diagram showing the active filter circuit of the second embodiment of the present invention. Referring to Fig. 3, T5a and T5b represent input transistors, T6a and T6b represent output transistors, R8a, R8b, R9a and R9b represent resistors, and CCS1a, CCS1b, and CCS3 represent constant current sources.

The input terminal of the circuit shown in Fig. 1(a) is connected to the collectors of the transistors T5a and T5b. The output terminal of the circuit shown in Fig. 1(a) are connected to the emitters of the transistors T6a and T6b.

In the circuit shown in Fig. 3, when the base voltage Vin of the transistor T5a and the base voltage Vin* of the transistor T5b are equal in amplitude but opposite in phase, the collector current of the transistor T5a and the collector current of the transistor T5b are equal in amplitude but opposite in phase while the collector voltages Vout of the transistors T6a and T6b are equal in amplitude but opposite in phase. Hence

$$(Vout - Vout^*) / (Vin - Vin^*) = (R_9 / R_8)\ (Iout / Iin) \tag{29}$$

Like the circuit shown in Fig. 2, the current transfer function is converted into the voltage transfer function in the circuit shown in Fig. 3. Thus the secondary low-pass filter shown in Fig. 1 can be easily realized as actual circuits. There is an advantage in that the amplifier built in the optical communications system can be largely improved in performance and the entire system can be miniaturized.

The circuit shown in Fig. 3 which has the bases of the transistors T5a and T5b acting as input terminals and the collectors of the transistors T6a and T6b acting as output terminals makes a balanced filter circuit. The circuit which has the bases of the transistors T5a and T5b acting as input terminals and the collector of the transistors T6a or T6b acting as output terminals makes a balanced-input / unbalanced-output type filter circuit.

Moreover, with the base of the transistor T5a or T5b acting as an input terminal and the base of the transistor T5b or T5a alternately grounded, and the collector of the transistors T6a and T6b acting as an output terminal, an unbalanced-input / balanced-output type filter circuit can be formed. With one of the transistors T5a and T5b having the base acting as an input terminal and the other of the transistor T5b and T5a having the base alternately grounded, and the transistor T6a or T6b having the collectors acting as output terminals, an unbalanced-input / unbalanced output type filter circuit can be formed.

The constant current sources CCS1a and CCS1b supply a bias current to the inductance forming transistor and the output transistor arranged in the black box within the circuit shown in Fig. 3 to enlarge the dynamic range thereof.

The circuit shown in Fig. 3 can be used for a balanced filter circuit, a balanced/unbalanced filter circuit, an unbalanced/balanced filter circuit, or an unbalanced filter circuit.

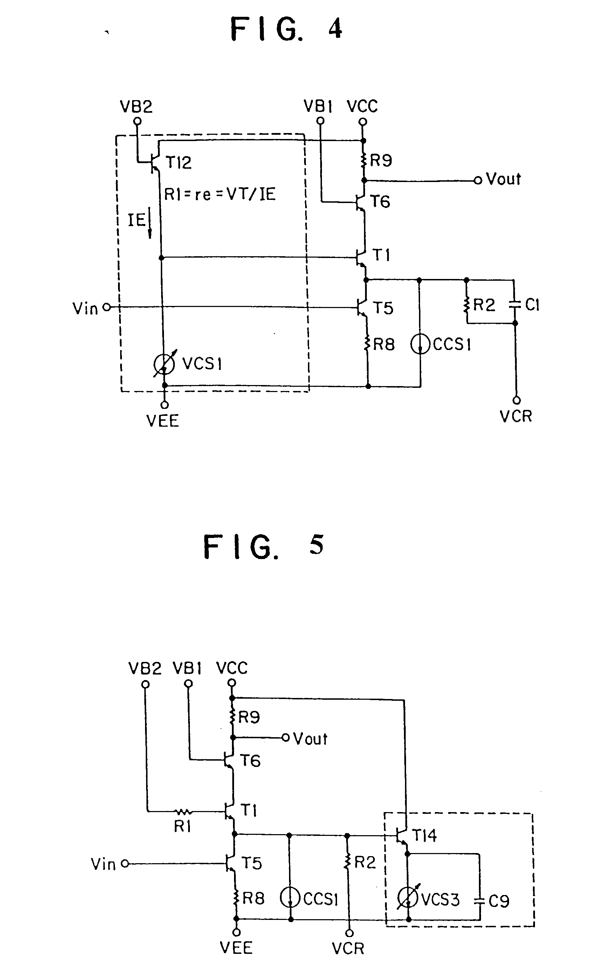

Fig. 4 is a diagram showing the active filter circuit according to the third embodiment of the present invention. Referring to Fig. 4, symbol T5 represents an input transistor, T1 represents an inductance forming transistor, T12 represents a transistor which forms a resistor connected to the base of the transistor T1, $R_8$, $R_2$, and $R_9$ represent resistors, $C_1$ represents a capacitor, CCS1 represents a constant current source, and VCS1 represents a variable constant current source which supplies the emitter current to the transistor T12.

The circuit shown in Fig. 4 corresponds to the circuit shown in Fig. 1 arranged in the black-box shown in Fig. 2. The resistor $R_1$ in Fig. 1 is substituted for the emitter resistor $r_e$ of the transistor T12 in Fig. 4.

When the emitter current is Ie (mA), the emitter resistor re is expressed as follows:

$$r_e = V_T / Ie \text{ (here, } V_T = 26mV) \tag{30}$$

$r_e$ of the formula (30) is substituted for the formula (4) and then the result is substituted for the formula (5). Thus the resultant frequency characteristic is the same as that of the circuit shown in Fig. 4.

As a result, in the circuit shown in Fig. 4, the resistor R1 of a fixed value in the circuit shown in Fig. 1 can be varied with the emitter current of the transistor T12. That is, according to the circuit shown in Fig. 4, a low-pass filter circuit with a secondary cut-off characteristic and a cut-off frequency capability can be realized as an actual circuit by varying the emitter current of the transistor T12 by means of the variable current source VCS1.

As described above, according to the active filter circuit of the third embodiment of the present invention, a secondary low-pass filter which can vary the cut-off frequency can be easily realized as an actual circuit such as an integrated circuit. Hence, the performance of the amplifier used for the optical communications system can be largely improved and the system can be effectively small-sized.

As for the circuit shown in Fig. 4 embodying the first aspect of the present invention, the resistor connected to the base of the transistor forming an inductance is substituted for the emitter resistor $r_e$ of the transistor driven by means of the variable current source.

Fig. 4 shows a signal-input and single-output type circuit. However, the substitution to a variable resistor can be applied to the differential amplifier-type circuit.

Fig. 5 is a diagram showing the active filter circuit according to the eleventh embodiment of the present invention. Referring to Fig. 5, T5 represents an input transistor, T1 represents a transistor forming an inductance, T6 represents an output transistor, T14 represents a transistor forming a capacitance, $R_8$, $R_1$, $R_9$ and $R_2$ represent resistors, $C_9$ represents a bypass capacitor which ac-grounds the emitter of the transistor T14, CCS1 represents a constant current source expanding the dynamic range, and VCS3 represents a variable current source which varies the emitter current.

The circuit shown in Fig. 5 can be formed by inserting the circuit shown in Fig. 1 in the black-box shown in Fig. 2. The capacitor $C_1$ shown in Fig. 1 is substituted for the input capacitance of the transistor T14 in Fig. 5.

Since the frequency characteristic is the same as that expressed by the formula (4), the circuit shown in Fig. 5 is a low-pass filter with a secondary cut-off characteristic.

As shown in Fig. 20, the transistor T14 has the input capacitance of $(Cd + C_{JE} + C_{JC})$ because the collector and emitter thereof are grounded alternatingly.

$Cd \gg C_{JE}, C_{JC}$ at a normal bias. Since depending on the electric charges injected from the emitter into the base and the emitter to base voltage, the emitter diffusion capacitance Cd is proportional to the emitter current.

Hence, since the input capacitance of the transistor T14 varies substantially and proportionally the current from the variable current source VCS3, the secondary low-pass filter shown in Fig. 5 can vary its cut-off frequency with the current from the variable current source VCS3.

According to the active filter circuit of the fourth embodiment of the present invention, the capacitance of the capacitor can be realized with the input capacitance of the transistor grounded with high-frequency. Hence the secondary low-pass filter circuit which can vary the cut-off frequency can be easily realized as an actual circuit, particularly, an integrated circuit without using a discrete coil. A cut-off frequency controllable low-pass filter circuit can be realized as an integrated circuit. Thus, the performance of the amplifier arranged in the optical communications system is more improved and the entire system can be effectively small-sized.

The circuit shown in Fig. 5 is a single-input and single-output type circuit. Substituting the above-mentioned capacitor for a variable capacitor can be applied to the differential amplifier-type circuit.

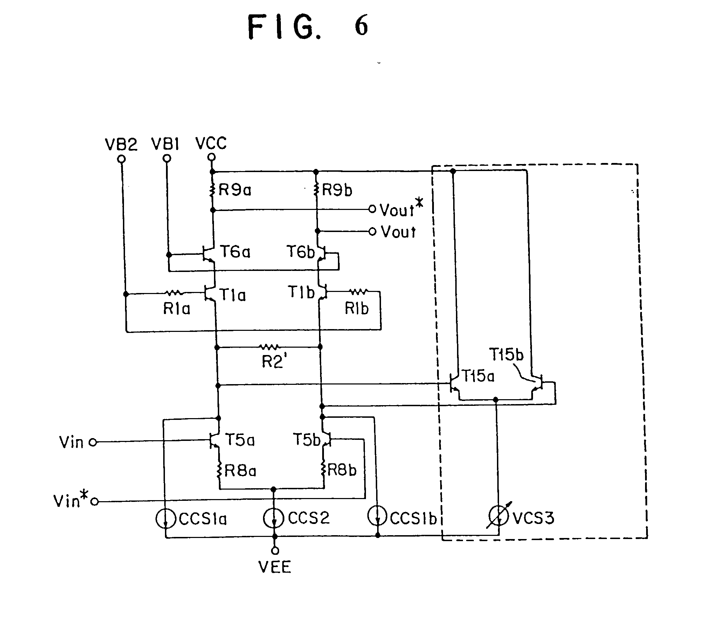

Fig. 6 is a diagram showing the active filter circuit according to the fifth embodiment of the present invention. Referring to Fig. 6, T5a and T5b represent input transistors, T1a and T1b represent transistors forming inductances, T6a and T6b represent output transistors, T15a and T15b represent transistors forming variable capacitors, R8a, R8b, R2', R1a, R1b, R9a and R9b represent resistors, CCS2 represents a constant current source, CCS1a and CCS1b represent constant current sources each expanding the dynamic range, and VCS3 represents a variable current sources each which varies the emitter current.

The circuit, shown in Fig. 6, is formed by applying the circuit shown in Fig. 1 to the black-box shown in Fig. 3. The capacitor C1 shown in Fig. 1 is substituted for the input capacitance of each of the transistors T15a and T15b.

The circuit shown in Fig. 6 has the same transfer function as that of the circuit shown in Fig. 1. The circuit shown in Fig. 6 is a low-pass filter having a secondary cut-off characteristic.

As shown in Fig. 6, the input capacitance of each of the transistors T15a and T15a is the sum of ($Cd + C_{JE} + C_{JC}$) because the juncture between the emitters of the transistors T15a and T15b is virtually grounded. Hence, the secondary low-pass filter circuit shown in Fig. 6 can vary the cut-off frequency in accordance with the current from the variable current source VCS3.

According to the active filter circuit of the fifth embodiment of the present invention, the secondary low-pass filter circuit which can vary the cut-off frequency can be easily realized as an actual circuit, particularly, an integrated circuit without using a discrete coil. Hence a low-pass filter circuit which can control the cut-off frequency can be realized as an integrated circuit. Thus, the performance of the amplifier arranged in the optical communications system is more improved and the entire system can be effectively small-sized.

According to the present embodiment, as described above, a pair of the active filter circuits embodying the first aspect of the present invention forms, as an example, a differential amplifying circuit. However, the method for varying a capacitance with a transistor can be applied to the circuit according to other aspects but should not be limited to the mode of the differential amplifier.

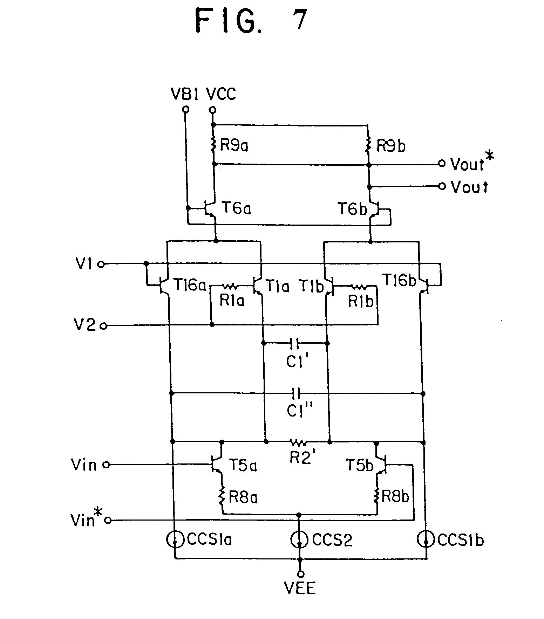

Fig. 7 is a diagram showing the active filter circuit according to the sixth embodiment of the present invention. Referring to Fig. 7, T5a and T5b represent input transistors, T1a and T1b represent transistors forming inductances, T16a and T16b represent transistors having the emitter resistors acting as resistors, T6a and T6b represent output transistors; R8a, R8b, R2', R1a, R1b, R9a and R9b represent resistors, $C_1'$ and $C_1''$ represent capacitors, CCS2 represents a constant current source, and CCS1a and CCS1b represent constant current sources each expanding the dynamic range.

The circuit of the transistors T5a, T1a and T6a (or of the transistors T5b, T16b and T6b) corresponds to the circuit in the black box shown in Fig. 1 to form a low pass filter circuit with a secondary cut-off frequency.

The circuit of the transistors T5a, T16a and T6a (or of the transistors T5b, T1b and T6b) corresponds basically to a low pass filter circuit with a first cut-off frequency characteristic shown in Fig. 11.

The circuit shown in Fig. 7 can switch the secondary low-pass filter circuit and the primary low-pass filter circuit by selectively setting the base bias voltage V2 for the transistors T1a and T1b and the base bias voltage V1 for the transistors T16a and T16b. In the circuit shown in Fig. 7, the secondary low-pass filter circuit is selected by flowing current through the transistors T1a and T1b, with the base bias voltage V1 set to a low value, the transistors T16a and T16b cut off, and the base bias voltage V2 set to a high value. On the contrary, the primary low-pass filter circuit is selected by supplying current through the transistors T16a and T16b, with the transistors T1a and T1b cut off.

As described above, the active filter circuit of the sixth embodiment of the present invention allows the same integrated circuit to have different functions, together with the effect of the secondary low-pass filter circuit. Hence there is an advantage in that the circuit designing flexibility can be improved.

In the circuit shown in Fig. 7, the resistors R1a and R1b can be replaced by the emitter resistance $r_e$ of the transistor to which current is supplied from the variable current source. The capacitors C1' and C1" can be replaced by the capacitance counting the base capacitance of the transistor to which current is supplied from the variable current source.

According to the present embodiment, the circuit where the primary low-pass filter circuit and the secondary low-pass filter circuit are combined and separated has been described as an example. However, the filter circuits combined should not be limited only to the above embodiment. Filter circuits with arbitrary characteristics can be combined. The filter circuit also should not be limited to the differential amplifier-type filter.

**EP 0 663 723 B1**

Fig. 9 is a graph showing the result simulated by using SPICE (circuit simulator).

Fig. 9 shows the characteristic of the low-pass filter circuit shown in Fig. 6. As shown in Fig. 9, the cut-off frequency decreases (because Cd increases proportionally) as the emitter current of the variable capacitance forming transistor increases.

In the above-mentioned embodiments, active filter circuits including bipolar transistors (referred to as normal transistors) acting as active elements have been described. Similar circuits having the basic operation can be formed using field-effect transistors.

The reason is that the impedance viewed from the source of the field effect transistor which has the gate grounded via a resistor can be expressed with the equivalent circuit shown in Fig. 8.

Because of a relatively low value of gm, it cannot be avoided that the filter circuit formed of field-effect transistors is inferior in the characteristic to the filter circuit formed of transistors. However, there is an advantage in that the filter circuit can be very easily formed with digital circuits on the same chip.

INDUSTRIAL APPLICABILITY

As described above, according to the present invention, the active secondary low-pass filter circuit, the secondary high-pass filter circuit, the secondary band-pass filter circuit, the resonance circuit, and the frequency band variable filter circuit which can vary the cut-off frequency and resonance frequency can be easily realized and integrated without using discrete components such as coils and capacitors. Hence these filter circuits are effective in improvement of its characteristics and shrinkage in size. The filter circuits also are suitable to control the frequency band of the amplifier that amplifies weakened signals particularly used for the optical communications system to an optimum value.

**Claims**

1.   A filter circuit comprising:

   -   a first transistor (T1) having a base or gate connected to ground or power source, via a first resistor (R1) ;

   -   a second resistor (R2) and a capacitor (C1) each having one end connected to an emitter or source of said first transistor (T1) and the other terminal connected to ground or said power source;

   -   a current input (Iin) at a juncture at which said second resistor (R2), said capacitor (C1), and said first transistor are connected together; and

   -   a collector or drain of said first transistor (T1) connected to constitute a current output (Iout).

2.   The filter circuit according to claim 1, wherein said first resistor (R1) is substituted for:

   -   a second transistor (T12) which has a base or gate connected to said power source (VB2) via an impedance of zero ohms or more; and

   -   said second transistor (T12) further having an emitter or source connected to a variable current source (VCS1) and connected to the base or gate of said first transistor (T1).

**Patentansprüche**

1.   Filterschaltung, umfassend:

   -   einen ersten Transistor (T1) mit einer Basis oder einem Gate, die/das mit Masse oder einer Energiequelle über einen ersten Widerstand (R1) verbunden ist;

   -   einen zweiten Widerstand (R2) und einen Kondensator (C1), wobei jeweils ein Ende davon mit einem Emitter oder einer Source des ersten Transistors (T1) verbunden ist und der andere Anschluss mit Masse oder der Energiequelle verbunden ist;

   -   einen Stromeingang (Iin) an einem Übergang, an dem der zweite Widerstand (R2), der Kondensator (C1) und der erste Transistor zusammengeschaltet sind; und

- einen Kollektor oder eine Drain des ersten Transistors (T1), der/die verbunden ist, um einen Stromausgang (Iout) zu bilden.

2. Filterschaltung nach Anspruch 1, wobei der erste Widerstand (R1) ersetzt ist durch:

- einen zweiten Transistor (T12), der eine Basis oder ein Gate aufweist, die/das mit der Energiequelle (VB2) über eine Impedanz von Null Ohm oder mehr verbunden ist; und
- wobei der zweite Transistor (T12) ferner einen Emitter oder eine Source aufweist, der/die mit einer variablen Stromquelle (VCS1) verbunden ist und mit der Basis oder dem Gate des ersten Transistors (T1) verbunden ist.

**Revendications**

1. Circuit filtrant comprenant :

- un premier transistor (T1) possédant une base ou une grille connectée à la terre ou à une source d'alimentation électrique, par l'intermédiaire d'une première résistance (R1) ;
- une seconde résistance (R2) et un condensateur (C1), chacun ayant une extrémité connectée à un émetteur ou à une source dudit premier transistor (T1) et l'autre borne étant connectée à la terre ou à ladite source d'alimentation électrique ;
- une entrée de courant (Iin) au niveau du point de jonction où ladite seconde résistance (R2), ledit condensateur (C1) et ledit premier transistor sont connectés ensemble ; et
- un collecteur ou un drain dudit premier transistor (T1) connecté pour constituer une sortie de courant (Iout).

2. Circuit filtrant selon la revendication 1, dans lequel ladite première résistance (R1) est remplacée par :

- un second transistor (T12) qui possède une base ou une grille connectée à ladite source d'alimentation électrique (VB2) par l'intermédiaire d'une impédance de zéro ohm ou plus ; et
- ledit second transistor (T12) possédant en outre un émetteur ou une source connecté à une source de courant variable (VCS1) et connecté à la base ou à la grille dudit premier transistor (T1).

# F I G. 1 (a)

POWER SOURCE OR GND

# F I G. 1 (b)

POWER SOURCE OR GND

# FIG. 2

# FIG. 3

# F I G. 4

# F I G. 5

# FIG. 6

# FIG. 7

# FIG. 8

# FIG. 9

# F I G. 10

OPTICAL SIGNAL INPUT

LIGHT RECEIVING ELEMENT — 1

2 — EQUALIGING AND AMPLIFYING CIRCUIT

3 — SLICING AND AMPLIFYING CIRCUT

7 — DECISION CIRCUT

DATA

TO S/P

4 — TIMING EXTRACTING CIRCUIT

5 — FILTER

6 — LIMITING AND AMPLIFYING CIRCUIT

CLOCK

# F I G. 11